(19) **Europäisches Patentamt**

**European Patent Office**

**Office européen des brevets**

(11) **EP 1 462 811 A1**

(12) **EUROPÄISCHE PATENTANMELDUNG**

(43) Veröffentlichungstag:
**29.09.2004 Patentblatt 2004/40**

(51) Int Cl.⁷: **G01R 15/24**, G01R 19/00

(21) Anmeldenummer: **03405271.2**

(22) Anmeldetag: **16.04.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **28.03.2003 EP 03405213**

(71) Anmelder: **ABB RESEARCH LTD.**
**8050 Zürich (CH)**

(72) Erfinder:
• **Bohnert, Klaus**
**5452 Oberrohrdorf (CH)**

• **Frank, Andreas**
**8037 Zürich (CH)**
• **Brändle, Hubert**
**8102 Oberengstringen (CH)**

(74) Vertreter: **ABB Patent Attorneys**
**c/o ABB Schweiz AG,**
**Intellectual Property (CH-LC/IP),**
**Brown Boveri Strasse 6**
**5400 Baden (CH)**

(54) **Elektrooptischer Spannungssensor für hohe Spannungen**

(57) Der Spannungssensor zur Messung einer zwischen zwei Elektroden (3,4) anliegenden Spannung V, die ein elektrisches Feld E erzeugt, beinhaltet mindestens zwei entlang eines Lichtweges (5) angeordnete Schichten (1a,2a) aus elektrooptisch aktivem Material. Die Schichten werden von einem Lichtstrahl durchlaufen, der aufgrund des elektrooptischen Effektes in seiner Phase und/oder seinem Polarisationszustand beeinflusst wird. Die Orientierung der elektrooptisch aktiven Schichten (1a,2a) relativ zum Lichtweg und dem elektrischen Feld E ist derart gewählt, dass die Beeinflussung des Lichtes (5) in der zweiten Schicht (2a) der Beeinflussung des Lichtes (5) in der ersten Schicht (1a) entgegenwirkt. Auf diese Weise kann ein Sensor mit einer hohen Halbwellenspannung realisiert werden, so dass hohe Spannungen V eindeutig messbar sind. Vorteilhaft werden mehrere erste und zweite elektrooptisch aktive Schichten zwischen den Elektroden (3,4) angeordnet.

**Fig. 1**

EP 1 462 811 A1

**Beschreibung**

Technisches Gebiet

Die Erfindung bezieht sich auf das Gebiet der elektrooptischen Spannungssensorik. Sie bezieht sich auf einen elektrooptischen Spannungssensor gemäss dem Oberbegriff des Patentanspruches 1 sowie auf ein Verfahren zur elektrooptischen Spannungsmessung gemäss dem Oberbegriff des Patentanspruches 14.

Stand der Technik

Ein derartiger Spannungssensor ist beispielsweise aus J.C. Santos, K. Hikada, "New Multi-Segment Pockels Device for High-Voltage Measurement", Proc. ICEE ' 96 (International Conference on Electrical Engineering), p. 1366-1370 bekannt. Der von Santos und Hikada beschriebene Sensor umfasst eine Vielzahl von Scheiben aus kristallinem BGO ($Bi_4Ge_3O_{12}$), welche beabstandet voneinander zwischen zwei Elektroden angeordnet sind, an welchen die zu messende Spannung V anliegt. Zylindrische dielektrische Abstandshalter dienen der Beabstandung der BGO-Scheiben, welche in gleichmässigen Abständen in einer Reihe hintereinander zwischen den Elektroden angeordnet sind. Die Zwischenräume zwischen den BGO-Scheiben und die Umgebung des Sensors sind mit $SF_6$ gefüllt.

Die BGO-Scheiben werden mit einem Lichtstrahl durchstrahlt, dessen Polarisationszustand sich aufgrund des Pockels-Effektes (linearer elektrooptischer Effekt) in Abhängigkeit von der Spannung V ändert. Insbesondere werden zwei zueinander orthogonal polarisierte Lichtwellen in die BGO-Kristalle eingekoppelt, die aufgrund der elektrooptischen Aktivität zueinander eine von der Spannung V abhängige Phasenverschiebung erfahren. Diese Phasenverschiebung wird detektiert und dient als Spannungssignal des Sensors.

Solange die Phasenverschiebung 180° nicht überschritten ist das Spannungssignal eindeutig. Die entsprechende maximale eindeutig bestimmbare Spannung ist die Halbwellenspannung $V_\pi$. Normalerweise wird der Sensor so ausgeführt, dass der eindeutige Bereich -90° bis +90° Phasenverschiebung enspricht. Die Spannung liegt dann im Bereich $-V_\pi/2$ bis $V_\pi/2$. Bei der Messung grosser Spannungen V wird diese Halbwellenspannung $V_\pi$ (oder $V_\pi/2$) bei herkömmlichen Sensoren, die einen einzigen elektrooptisch aktiven Kristall zwischen den Elektroden aufweisen, rasch überschritten. Durch die von Santos und Hikada vorgeschlagene Anordnung einzelner dünner Scheiben elektrooptisch aktiven Materials kann die gesamte detektierte Phasenschiebung deutlich verringert werden. Dabei wird das Linienintegral über das elektrische Feld zwischen den Elektroden, welches die genaue Spannung V angibt, ersetzt durch eine (gwichtete) Summe über die elektrischen Felder in den einzelnen BGO-Scheiben. Die Phasenverschiebungen in jeder der in diskreten Abständen zueinander angeordneten BGO-Scheiben tragen zu der Gesamt-Phasenverschiebung bei, wobei auch bei grossen Spannungen V die Halbwellenspannung $V_\pi$ nicht überschritten wird, so dass eindeutige Messergebnisse erzielt werden.

Darstellung der Erfindung

Es ist Aufgabe der Erfindung, einen alternativen elektrooptischen Spannungssensor der eingangs genannten Art zu schaffen sowie ein entsprechendes alternatives Messverfahren. Es soll ein Spannungssensor geschaffen werden, welcher eine eindeutige Messung hoher Spannungen erlaubt.

Diese Aufgabe löst ein elektrooptischer Spannungssensor mit den Merkmalen des Patentanspruches 1 und ein entsprechendes Messverfahren mit den Merkmalen des Patentanspruches 14.

Ein erfindungsgemässer Spannungssensor weist zwei beabstandete Elektroden auf, zwischen welchen eine zu messende Spannung V anliegt. Durch die anliegende Spannung V wird ein elektrisches Feld E erzeugt. Zwischen den Elektroden sind mindestens eine erste elektrooptisch aktive Schicht und mindestens eine zweite elektrooptisch aktive Schicht entlang eines Lichtweges hintereinander angeordnet. Jede der zwei elektrooptisch aktiven Schichten weist mindestens zwei Achsen der Doppelbrechung auf, wobei jeder der Achsen je ein Brechungsindex zugeordnet ist. Das heisst, dass linear polarisiertes Licht, dessen Polarisationsrichtung entlang einer solchen Achse der Doppelbrechung ausgerichtet ist, den entsprechenden Brechungsindex "sieht". Aus den unterschiedlichen Brechungsindices für die zwei Achsen der Doppelbrechung ergeben sich unterschiedliche Ausbreitungsgeschwindigkeiten der entsprechenden linear polarisierten Wellen, weshalb man auch von einer schnellen und einer langsamen Achse (der Doppelbrechung) spricht. Dadurch, dass die beiden Schichten elektrooptisch aktiv sind, gibt es pro Schicht mindestens jeweils einen Brechungsindex (und eine dazugehörige Achse der Doppelbrechung), der sich in Abhängigkeit von dem elektrischen Feld E ändert. Durch derartige Brechungsindexänderungen ist in jeder dieser Schichten eine Phasenlage (kurz: Phase) und/oder ein Polarisationszustand des sich entlang des Lichtweges ausbreitenden Lichtes beinflussbar.

Der erfindungsgemässe Spannungssensor kennzeichnet sich dadurch, dass eine durch die entsprechenden Achsen der Doppelbrechung definierte Orientierung der mindestens einen ersten elektrooptisch aktiven Schicht relativ zu dem Lichtweg und dem elektrischen Feld E und eine durch die entsprechenden Achsen der Doppelbrechung definierte Orientierung der mindestens einen zweiten elektrooptisch aktiven Schicht relativ zu dem Lichtweg und dem elektrischen Feld E derart gewählt sind, dass die Beeinflussung der Phase und/oder des Polarisationszustandes des Lichtes in der ersten Schicht der Beeinflussung der Phase und/oder des Polarisationszustandes des Lichtes in der zweiten Schicht entgegenwirkend ist.

Wird beispielsweise linear polarisiertes Licht unter 45° zu zwei Achsen der Doppelbrechung in die erste elektrooptisch aktive Schicht eingekoppelt, so dass sich das Licht in den elektrooptisch aktiven Schichten in Form zweier zueinander orthogonal polarisierter Lichtwellen ausbreitet, so kann als Spannungssignal eine gegenseitige Phasenverschiebung dieser Wellen oder ein Polarisationszustand des aus den Schichten ausgetretenen Lichtes gemessen werden. Wird andererseits beispielsweise eine linear polarisierte Lichtwelle unter 0° oder 90° in die erste elektrooptisch aktive Schicht eingekoppelt, so dass sich das Licht in beiden elektrooptisch aktiven Schichten in Form einer einzigen linear polarisierten Lichtwelle ausbreitet, so kann als Spannungssignal eine Phase dieser Welle gemessen werden.

Die kristallographische Orientierung der elektrooptisch aktiven Schichten ist derart gewählt, dass eine vergrösserte Halbwellenspannung $V_\pi$ des Sensors erzeugt wird. Eine grössere Halbwellenspannung $V_\pi$ wird in dem Sinne erzielt, dass die Halbwellenspannung $V_\pi$ des Sensors grösser ist als eine Halbwellenspannung eines gleichartigen Sensors, der sich nur dadurch von dem Sensor unterscheidet, dass die mindestens eine zweite Schicht nicht elektrooptisch aktiv ist.

Mittels der Brechungsindexänderungen ist für einen die elektrooptisch aktiven Schichten durchstrahlenden Lichtstrahl eine Halbwellenspannung $V_\pi$ des Sensors definierbar. Wird der Sensor, oder genauer: die elektrooptisch aktiven Schichten, in geeigneter Weise von einem Lichtstrahl durchstrahlt, so verändert sich die Phase und/oder der Polarisationszustand des Lichtstrahles in Abhängigkeit von dem elektrischen Feld. Aus einer solchen Änderung der Phase und/oder des Polarisationszustandes des Lichtes kann ein Spannungssignal des Sensors gewonnen werden. Aufgrund der Wellennatur des Lichtes ist ein solches Signal aber periodisch, so dass oberhalb einer für den Sensor charakteristischen Spannung, der Halbwellenspannung $V_\pi$, das Spannungssignal mehrdeutig ist. Eine eindeutige Spannungsmessung kann nur im Bereich von 0 V bis $V_\pi$ (oder $-V_\pi/2$ bis $V_\pi/2$) stattfinden. Wird als Spannungssignal beispielsweise eine gegenseitige Phasenverschiebung zweier Lichtwellen gemessen, so wird der 180° (= $\pi$ in radiant) umfassende eindeutige Bereich der Phasenverschiebung auf den Spannungsbereich von 0 V bis $V_\pi$ (oder $-V_\pi/2$ bis $V_\pi/2$) abgebildet. Wird als Spannungssignal die Phasenlage einer einzigen linear polarisierten Lichtwelle gemessen, so ist der eindeutige Bereich der Veränderung der Phase ebenfalls 180° (= $\pi$ in radiant) gross.

Wenn eine Halbwellenspannung $V_\pi$ mittels der Brechungsindexänderungen und des Lichtstrahles definierbar ist, ist ein prinzipielles Funktionieren des Spannungssensor sichergestellt. Verschiedene, dem Fachmann bekannte und geläufige Voraussetzungen, beispielsweise bezüglich des elektrischen Feldes E, des Lichtes (Lichtweg, Polarisation) sowie bezüglich deren gegenseitiger Anordnung, sind somit erfüllt.

Ausser der Orientierung der elektrooptisch aktiven Schichten können auch noch deren effektive Schichtdicken sowie die Art des Materials, aus denen die Schichten bestehen, gewählt werden, um eine gewünschte Halbwellenspannung zu erreichen.

In dem Sensor wird ein Lichtstrahl in die elektrooptisch aktiven Schichten eingestrahlt, der in den elektrooptisch aktiven Schichten abhängig von dem elektrischen Feld beeinflusst wird, und der danach detektiert wird. Aus dem nach dem Durchlaufen der Schichten detektierten Licht wird dann ein Spannungssignal gewonnen. Die Beeinflussung, die das Licht in der mindestens einen ersten elektrooptisch aktiven Schicht erfährt, wird in der mindestens einen zweiten elektrooptisch aktiven Schicht teilweise wieder rückgängig gemacht, das heisst teilkompensiert. Dadurch wird ein gleichgrosses Spannungssignal erst bei einer höhreren Spannung V erreicht, so dass eine grössere Halbwellenspannung $V_\pi$ resultiert.

Im einfachsten Fall nimmt man zwei Schichten aus demselben Material, beispielsweise BGO, wobei die erste BGO-Schicht etwas dünner ist als die zweite BGO-Schicht, gemessen entlang einer durch den Abstand der zwei Elektroden definierten Koordinate. Die Schichten werden entlang eben dieser Koordinate von Licht durchstrahlt. Die kristallinen BGO-Schichten sind dabei so zueinander orientiert, dass in dem bevorzugten Fall die [001]-Richtungen der Kristalle antiparallel zueinander ausgerichtet sind, während die [010]-Richtungen parallel und die [100]-Richtungen antiparallel (oder, alternativ, die [010]-Richtungen antiparallel und die [100]-Richtungen parallel) zueinander ausgerichtet sind. Im Falle identischer Schichtdicken würden sich die elektrooptisch induzierten Einflüsse auf das Licht in der ersten und in der zweiten Schicht genau aufheben, da sie nicht nur entgegengesetzt, sondern auch noch gleich gross wären.

Ein elektrooptisch aktives Material (elektrooptischer Kristall) weist zwei für einen den Kristall abfragenden Lichtstrahl relevante Achsen der Doppelbrechung auf (abhängig von der Elektrodengeometrie, dem Lichtweg und den Kristallgeometrien). Diese Achsen sind (paarweise) senkrecht zueinander ausgerichtet. Ein in geeigneter Weise erzeugtes elektrisches Feld führt zu einer Änderung der Doppelbrechung bezüglich dieser Achsen. Das heisst, dass sich für mindestens eine dieser Achsen der ihr zugeordnete Brechungsindex in Abhängigkeit von dem Feld E ändert. Eine erfindungsgemässe gegenseitige Orientierung der elektrooptisch aktiven Schichten kann gut über die gegenseitige relative Orientierung dieser zwei Achsen der Doppelbrechung definiert werden.

Die gegenseitige Orientierung der elektrooptisch aktiven Schichten ist derart gewählt, dass die Wirkung, die das elektrische Feld auf einen die mindestens zwei elektrooptisch aktiven Schichten abtastenden Lichtstrahl in der ersten elektrooptisch aktiven Schicht hat, zu einem Teil durch die Wirkung, die das elektrische Feld auf den die mindestens zwei elektrooptisch aktiven Schichten abtastenden Lichtstrahl in der zweiten elektrooptisch aktiven Schicht hat, kompensiert oder aufgehoben wird. Anders formuliert sind die Vorzeichen der genannten Wirkungen in den zwei elektrooptisch aktiven Schichten einander entgegengesetzt. Da durch den elektrooptischen Effekt stets Phasenverschiebungen des Lichtes stattfinden, ist stets ein Vorzeichen einer solchen Wirkung definierbar.

Ein erfindungsgemässer Sensor hat den Vorteil, dass er auch bei grossen Spannungen noch eindeutige Spannungssignale liefert. Somit sind sichere Messungen im Hochspannungsbereich (typischerweise 100 kV bis 1000 kV) möglich. Ausserdem ist es möglich, einen solchen Sensor zu realisieren, der nur sehr geringe Reflexionsverluste aufweist.

In einer vorteilhaften Ausführungsform weisen die beiden Schichten dieselbe Kristallsymmetrie auf, und die Schichten sind derart orientiert, dass die kristalline Orientierung der zweiten Schicht sich aus der kristallinen Orientierung der ersten Schicht durch eine Drehung der ersten Schicht um 180° um eine der Achsen der Doppelbrechung der ersten Schicht ergibt. Dies erlaubt es, eine relativ einfache Interpretation der Spannungssignale zu erreichen.

Vorteilhaft können die Schichten aus demselben Material bestehen. Reflexionen an Grenzflächen zwischen verschiedenen Schichten werden so minimiert.

In einer besonders bevorzugten Ausführungsform bestehen die Schichten aus demselben Material und sind mit genannten kristallinen Orientierung (um 180° um eine Doppelbrechungsachse gegeneinander rotiert) angeordnet und weisen effektive Schichtdicken $\delta_1, \delta_2$ auf, die voneinander verschieden sind. Über den Unterschied der Schichtdicken $\delta_1, \delta_2$ kann die Halbwellenspannung $V_\pi$ des Sensors gewählt werden.

Besonders vorteilhaft sind zwischen den Elektroden mehrere paarweise angeordnete erste und zweite Schichten angeordnet. Dadurch kann eine genaue und gegenüber externen Störungen der Feldverteilung unempfindliche Spannungsmessung erreicht werden.

Insbesondere kann die Mehrzahl paarweise angeordneter erster und zweiter elektrooptisch aktiver Schichten zwischen den Elektroden derart angeordnet sein, dass eine Abweichung der mittels des Spannungssensors bestimmten Spannung von der zu messenden Spannung V minimal ist. Eine Abweichung des Spannungssignals des Sensors, also der mittels des Spannungssensors bestimmten Spannung, von der zu messenden Spannung V ist dann also unterhalb einer vorgebbaren Grenze. Eine solche Anordnung der Schichten ist beispielsweise mittels Näherungsrechnungen oder Simulationen bestimmbar. Es können besonders genaue Messungen und eine grosse Unempfindlichkeit gegen äussere Störungen des elektrischen Feldes, beispielsweise aufgrund von Regen oder Schnee in Sensornähe, und gegen Querfelder, beispielsweise aufgrund von benachbarten elektrischen Phasen nahe dem Sensor, erzielt werden.

Eine weitere vorteilhafte Ausführungsform kennzeichnet sich dadurch, dass die Schichten stapelförmig zwischen den Elektroden angeordnet sind, wobei die erste Schicht und die letzte Schicht in dem Stapel mit je einer der zwei Elektroden in Kontakt ist. Insbesondere kann der Stapel vorteilhaft im wesentlichen zylindrisch ausgestaltet sein. Die Schichten bilden vorzugsweise einen Sensorstab. Ein mechanisch stabiler Aufbau mit grosser dielektrischer Festigkeit wird so realisiert.

Besonders vorteilhaft kann der Sensor auch derart gestaltet sein, dass er ein im wesentlichen von der Temperatur unabhängiges Spannungssignal liefert. Dies wird durch eine geeignete Wahl der Materialien der zwischen den Elektroden angeordneten Schichten und deren effektiver Schichtdicken realisiert. Die jeweiligen Einflüsse von Materialkonstanten wie

- massgeblicher elektrooptischer Koeffizient (k),
- Dielektrizitätskonstante ($\epsilon$) und
- thermischer Ausdehnungskoeffizient ($\alpha$)

auf die Temperaturabhängigkeit des Spannungssignals können derartig gewählt werden, dass die resultierende gesamte Temperaturabhängigkeit des Spannungssignals im wesentlichen verschwindet. Das Spannungssignal wird im allgemeinen aus der detektierten Phase und/oder dem detektierten Polarisationszustand des Lichtes gewonnen.

Vorteilhaft, insbesondere in Kombination mit der genannten Temperaturkompensation, können auch noch eine oder mehrere nicht-elektrooptisch-aktive Abstandsschichten zwischen den Elektroden angeordnet sein. Dadurch werden weitere Freiheitsgrade für das Design des Sensors gewonnen.

Eine besonders vorteilhafte Ausführungsform kennzeichnet sich dadurch, dass die Schichten aus kristallinem BGO (Wismut-Germanium-Oxid, $Bi_4Ge_3O_{12}$) bestehen, wobei das BGO in der ersten und zweiten Schicht mit seiner [001]-Richtung parallel respektive antiparallel zur Ausbreitungsrichtung des Lichtes orientiert ist, und wobei die Ausbreitungsrichtung des Lichtes im wesentlichen entlang des von der Spannung V erzeugten elektrischen Feldes E verläuft. Die [110]-Richtungen der Kristalle sind dabei vorteilhaft im wesentlichen parallel oder antiparallel ausgerichtet.

Besonders vorteilhaft können die Elektroden mitsamt den zwischen den Elektroden angeordneten Schichten in Silikon eingegossen werden. Durch die Silikonummantelung ist ein Sensor mit sehr geringen Abmessungen und geringem Gewicht herstellbar, der trotzdem über eine ausreichende elektrische Isolation verfügt. Teure, grosse, schwere Isolationsrohre, typischerweise aus glasfaserverstärktem Kunststoff, können vermieden werden. Das geringe Gewicht und die kleinen Abmessungen ermöglichen einen Einsatz des Sensors an Stellen oder in Lagen, an oder in denen konventionell isolierte Sensoren nicht einsetzbar sind. Beispielsweise hängend an einem hochspannungsführenden Anlagenteil.

Vorteilhaft ist der Sensor ausgelegt zur Messung von Spannungen V, die kleiner oder gleich einer maximal zu messenden Spannung $V_{max}$ sind, wobei die Anzahl und Orientierung der ersten und zweiten Schichten und deren effektiven Schichtdicken und die Materialien, aus denen die Schichten bestehen, derart gewählt sind, dass $V_{max}$ kleiner oder gleich der Halbwellenspannung $V_\pi$ des Sensors ist.

Das erfindungsgemässe Verfahren Messung einer elektrischen Spannung V,

wobei die Spannung V zwischen zwei voneinander beanstandet angeordneten Elektroden anliegt und ein elektrisches Feld E erzeugt, wobei zwischen den Elektroden mindestens eine erste elektrooptisch aktive Schicht angeordnet wird, welche von einem Lichtstrahl durchlaufen wird, dessen Phase und/oder Polarisationszustand durch das elektrische Feld E in der ersten Schicht beeinflusst wird, und wobei zwischen den Elektroden mindestens eine zweite elektrooptisch aktive Schicht angeordnet wird, welche von dem Lichtstrahl durchlaufen wird, dessen Phase und/oder Polarisationszustand durch das elektrische Feld in der zweiten Schicht beeinflusst wird, kennzeichnet sich dadurch, dass die von dem Lichtstrahl in der mindestens einen ersten Schicht erfahrene Beeinflussung von der von dem Lichtstrahl in der mindestens einen zweiten Schicht erfahrenen Beeinflussung teilweise aufgehoben wird.

Weitere bevorzugte Ausführungsformen und Vorteile gehen aus den abhängigen Patentansprüchen und den Figuren hervor.

Kurze Beschreibung der Zeichnungen

Im folgenden wird der Erfindungsgegenstand anhand von bevorzugten Ausführungsbeispielen, welche in den beiliegenden Zeichnungen dargestellt sind, näher erläutert. Es zeigen:

Fig. 1    einen erfindungsgemässen Spannungssensor, stark schematisiert, mit angedeuteten Kristallorientierungen;

Fig. 2    einen erfindungsgemässen Spannungssensor mit vier Paaren von ersten und zweiten elektrooptisch aktiven Schichten, schematisch;

Fig. 3    einen erfindungsgemässen Spannungssensor in Transmissionsgeometrie, mit drei Paaren von ersten und zweiten elektrooptisch aktiven Schichten, schematisch;

Fig. 4    einen erfindungsgemässen Spannungssensor mit Silikonummantelung, schematisch.

Die in den Zeichnungen verwendeten Bezugszeichen und deren Bedeutung sind in der Bezugszeichenliste zusammengefasst aufgelistet. Grundsätzlich sind in den Figuren gleiche oder zumindest gleichwirkende Teile mit gleichen Bezugszeichen versehen. Die beschriebenen Ausführungsbeispiele stehen beispielhaft für den Erfindungsgegenstand und haben keine beschränkende Wirkung.

Wege zur Ausführung der Erfindung

Am 28.03.2003 wurde vom gleichen Anmelder beim europäischen Patentamt eine noch unveröffentlichte Patentanmeldung derselben Erfinder mit der Anmeldenummer 03405213.4 dem Titel "Temperaturkompensierter elektrooptischer Spannungssensor" eingereicht. Diese EP-Anmeldung wird hiermit ausdrücklich mit ihrem gesamten Offenbarungsgehalt in die vorliegende Patentanmeldung aufgenommen. Darin sind Spannungssensoren, Verfahren und Details offenbart, die vollumfänglich Bestandteil der vorliegenden Patentanmeldung sein sollen.

Grundlagen und Details zur elektrooptischen Spannungsmessung können dem Stand der Technik entnommen werden, beispielsweise der genannten EP 0 682 261 A2. Der Offenbarungsgehalt dieser Schrift ist hiermit ausdrücklich in die Beschreibung übernommen. Weitere Grundlagen der elektrooptischen Spannungsmessung und Detektion sind beispielsweise der Publikation G.A. Massey, D.C. Erickson, and R.A. Kadlec, Applied Optics 14, 2712-2719, 1975 zu entnehmen. Der Offenbarungsgehalt dieses Textes ist hiermit ausdrücklich in die Beschreibung übernommen.

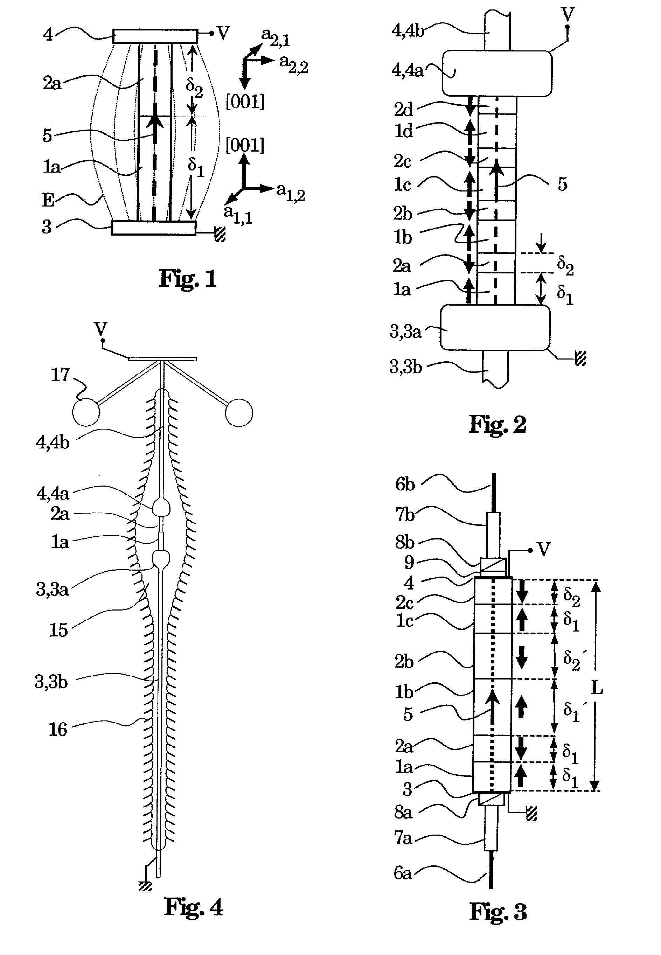

Fig. 1 zeigt stark schematisiert einen erfindungsgemässen Spannungssensor. Zwischen zwei Elektroden 3,4, zwischen welchen eine zu messende Spannung V anliegt, sind zwei Schichten 1a,2a aus elektrooptisch aktivem Material, vorteilhaft BGO-Schichten, angeordnet. Die Spannung V erzeugt ein elektrisches Feld E. Die Schichtdicke der ersten Schicht 1a ist $\delta_1$, die Schichtdicke der zweiten Schicht 1a ist $\delta_2$. Ein Lichtstrahl 5 durchstrahlt beide Schichten 1a,2a. Details zu den Eigenschaften des Lichtes 5, zu seiner Erzeugung und Detektion können der genannten unveröffentlichten EP-Anmeldung entnommen werden.

Die beiden elektrooptisch aktiven Schichten 1a,2a sind als zylindrische Elemente ausgebildet, die zusammen einen Sensorstab bilden, der sich von der einen Elektrode 3 zu der anderen Elektrode 4 erstreckt. Die Gesamtlänge des Sensorstabes entspricht hier also einem Elektrodenabstand L. Es gilt hier also $\delta_1 + \delta_2 = L$. In der Fig. 1 ist rechts neben dem Sensor die kristalline Orientierung der beiden BGO-Schichten 1a,2a veranschaulicht. Die [001]-Richtungen (entlang der sich hier das Licht 5 ausbreitet, und welche aufgrund der Kristallsymmetrie zu [010] und [100] äquivalent sind,) sind antiparallel zueinander ausgerichtet und zeigen entlang einer durch die Elektroden 3,4 (oder deren Abstand) vorgegebenen Koordinate, entlang welcher auch die Achse des Sensorstabes ausgerichtet ist. Mit $a_{1,1}$ und $a_{1,2}$ sind zwei für den Sensor relevante Achsen der Doppelbrechung der ersten elektrooptisch aktiven Schicht 1a bezeichnet. Analog sind mit $a_{2,1}$ und $a_{2,2}$ zwei für den Sensor relevante Achsen der Doppelbrechung der zweiten elektrooptisch aktiven Schicht 2a bezeichnet. Für BGO entsprechen diese Achsen der Doppelbrechung den [110]- und [$\bar{1}$10]-Kristallrichtungen. Die relative kristalline Orientierung der zwei Schichten 1 a,2a ist derart, dass sich die kristalline Orientierung der zweiten Schicht 2a sich aus der kristallinen Orientierung der ersten Schicht 1a durch eine Drehung der ersten Schicht 1a um 180° um eine der Achsen der Doppelbrechung $a_{1,1}$ oder $a_{1,2}$ (entsprechend [110] oder [$\bar{1}$10]) ergibt.

Die korrespondierenden Achsen $a_{1,1}$ und $a_{2,1}$ der ersten beziehungsweise zweiten Schicht sind parallel zueinander ausgerichtet, wie auch die korrespondierenden Achsen $a_{1,2}$ und $a_{2,2}$. Im ersten Fall ($a_{1,1}$ und $a_{2,1}$) sind die zu den Achsen parallel verlaufenden Kristallrichtungen antiparallel zueinander ausgerichtet, im zweiten Fall ($a_{1,2}$ und $a_{2,2}$) parallel.

Die genannten Achsen $a_{i,1}$ und $a_{i,2}$, wobei der Index i die entsprechenden elektrooptisch aktiven Schichten indiziert, sind als "für den Sensor relevante" Achsen der Doppelbrechung bezeichnet, weil sich in Abhängigkeit von dem elektrischen Feld E in jeder der Schichten mindestens ein einer der Achsen zugeordneter Brechungsindex $n_{i,1}$ und $n_{i,2}$ ändert. Dabei erfährt der die Schichten 1a,2a durchstrahlende Lichtstrahl 5 eine elektrooptisch hervorgerufene Beeinflussung. Diese Beeinflussung wird im allgemeinen als ein veränderter Polarisationszustand oder als eine veränderte Phasenlage des Lichtes 5 detektiert.

Welchen Kristallrichtungen ein für den Sensor relevantes Paar von Doppelbrechungsachsen entspricht, hängt von der Kristallsymmetrie und der Richtung der Lichtausbreitung und der Richtung des elektrischen Feldes E ab. Ein funktionsfähiger Sensor weist ein solches Paar von Achsen der Doppelbrechung in mindestens zwei, vorteilhaft allen elektrooptisch aktiven Schichten auf.

Aufgrund der in Fig. 1 dargestellten Anordnung der Kristallorientierungen der Schichten 1a,2a teilkompensieren sich die Beeinflussungen, die das Licht 5 in der ersten und in der zweiten Schicht erfährt. Wenn die Lichteingenschaften und die Licht-Einkopplung wie weiter unten im Zusammenhang mit Fig. 3 beschrieben gestaltet sind, erfahren die zwei zueinander orthogonal polarisierten Lichtwellen, aus welchen der Lichtstrahl 5 besteht, in der ersten Schicht 1a zueinander eine Phasenverschiebung von

$$\Gamma_1 = k_1 \cdot E \cdot \delta \cdot 2\pi/\lambda,$$

und in der zweiten Schicht 2a zueinander eine Phasenverschiebung von

$$\Gamma_2 = k_2 \cdot E \cdot \delta_2 \cdot 2\pi/\lambda,$$

wobei $\lambda$ die Wellenlänge des Lichtes 5 ist, und wobei $k_1$, $k_2$ massgebliche elektrooptische Koeffizienten der Materialien sind, aus denen die erste beziehungsweise zweite Schicht besteht. Hier sind sie entgegengesetzt gleich gross:

$$k_1 = -k_2 = n_0{}^3 r_{41} \, ,$$

weil beide Schichten 1a,2a aus demselben Material sind und die Kristalle in der genannten Weise zueinander orientiert sind (180° um Doppelbrechungsachse gegeneinander rotiert), wobei no der Brechungsindex von BGO für ein verschwindendes elektrisches Feld (E = 0) und $r_{41}$ das relevante elektrooptische Tensorelement für kristallines BGO (in der Orientierung der ersten Schicht 1a) ist. Im Falle von BGO und für die betrachtete Kristallorietierung gilt $n_{i,1} = n_0 + (1/2) k_i \cdot E$ und $n_{i,2} = n_0 - (1/2) k_i \cdot E$.

Somit ergibt sich für eine Gesamtphasenverschiebung $\Gamma$, die zwischen den orthogonal zueinander polarisierten Lichtwellen nach Durchlaufen der beiden Schichten 1a,2a vorliegt:

$$\Gamma = k_1 \cdot E \cdot (\delta_1 - \delta_2) \cdot 2\pi/\lambda.$$

Daraus ist ersichtlich, dass über die Wahl der Schichtdicken $\delta_1, \delta_2$ die Grösse der Gesamtphasenverschiebung $\Gamma$ reduzierbar ist gegenüber den einzelnen Phasenverschiebungen $\Gamma_1$, $\Gamma_2$ in den Schichten 1a,2a oder deren Summe. Die Gesamtphasenverschiebung $\Gamma$ als Spannungssignal kann also herunterskaliert werden.

Ein Zahlenbeispiel zu Veranschaulichung: Wenn beispielsweise nur die erste Schicht 1a elektrooptisch aktiv wäre, und die zweite Schicht 2a keine elektrooptische Aktivität aufwiese (bei sonst gleichartigen Eigenschaften), so könnte beispielsweise bei einer Spannung V von V = 10 kV die Gesamtphasenverschiebung $\Gamma = \Gamma_1 = 180°$ betragen. Die Halbwellenspannung des Sensors betrüge dann 10 kV; in der zweiten Schicht tritt dabei keine Phasenverschiebung auf. Wenn aber, erfindungsgemäss, die zweite Schicht elektrooptisch aktiv, und wie in Fig. 1 dargestellt ausgebildet ist, wird die Halbwellenspannung grösser sein. Wenn beispielsweise $\delta_2 = 0.9 \cdot \delta_1$ gewählt ist, beträgt die Gesamtphasenverschiebung $\Gamma$ bei den genannten V = 10 kV genau $\Gamma = (1 - 0.9) \cdot 180° = 18°$, so dass die Halbwellenspannung 100 kV statt 10 kV beträgt. Auf diese Weise kann die Halbwellenspannung $V_\pi$ und damit der Spannungsbereich, in dem eindeutige Spannungssignale gewonnen werden können, um beliebige Faktoren vergrössert werden.

Gegenüber dem Fall, dass keine zweite Schicht vorhanden wäre, und der gesamte Elektrodenabstand L mit einem einzigen BGO-Kristall als Sensorstab überbrückt würde, kann durch die Anordnung zweier entsprechend orientierter Kristalle oder Schichten natürlich eine noch grössere Erhöhung der Halbwellenspannung $V_\pi$ erzielt werden.

In Fig. 2 ist eine besonders vorteilhafte Ausführungsform der Erfindung dargestellt. Hier ist nicht nur ein einzelnes Paar zweier elektrooptisch aktiver Schichten 1a,2a zwischen den Elektroden 3,4 angeordnet, sondern eine Mehrzahl, nämlich vier, erster und zweiter elektrooptisch aktiver Schichten 1a,1b,1c,1d, 2a,2b,2c, 2d. Diese sind vorteilhaft paarweise angeordnet, so dass immer erste und zweite Schichten im Lichtweg 5 hintereinander angeordnet sind und hier sogar aneinandergrenzen. Der Sensorstab besteht also aus einem Stapel alternierend angeordneter erster und zweiter Schichten. Vorteilhaft ist die kristalline Orientierung der Schichten 1a,1b,1c,1d, 2a,2b,2c,2d gewählt wie es in der Fig. 1 angegeben ist. Die dicken Pfeile links neben dem Sensorstab veranschaulichen die [001]-Richtung. Die einander entsprechenden Achsen der Doppelbrechung verschiedener Paare sind dabei entweder parallel oder antiparallel zueinander ausgerichtet. Die Schichtdicken $\delta_1,\delta_2$ sind hier für alle ersten beziehungsweise zweiten Schichten gleich gewählt. In Fig. 2 weisen die Elektroden 3,4 Feldsteuerungselektroden 3a,4a und Spannungszuführungen 3c,4c auf.

Durch die paarweise Anordnung mehrerer erster und zweiter elektrooptisch aktiver Schichten 1a,1b, 1c,1d, 2a,2b,2c,2d kann eine genauere Spannungsmessung und eine deutlich verringerte Störempfindlichkeit gegen äussere Störungen der Feldverteilung erreicht. Jede Schicht kann seine eigene Schichtdicke $(\delta_1^{(a)}, \delta_2^{(a)}, \delta_1^{(b)}, \delta_2^{(b)} ...)$ aufweisen, die verschieden sein kann von den anderen Schichtdicken. In der genannten Unveröffentlichten EP-Anmeldung sind Wege beschrieben, die Anordnung derart zu optimieren, dass die Abweichung der gemessenen Spannung von der zu messenden Spannung V minimiert ist. In dem Patent US 4'939'447 und in der Publikation Optics Letters 14, 290, 1989 sind Details dazu angegeben. Der Offenbarungsgehalt dieser Texte ist hiermit ausdrücklich in die Beschreibung übernommen.

Jedes Schichtenpaar liefert ein Teil-Spannungssignal, das ein Mass für das im Bereich des betreffenden Schichtenpaars herrschende elektrische Feld ist. Vorteilhaft werden alle Paare mit einem einzigen Lichtstrahl 5 abgetastet.

Fig. 3 zeigt schematisch einen Spannungssensor, wobei insbesondere die optischen Komponenten des Sensors dargestellt sind. Die Bezugszeichen sind der Bezugszeichenliste zu entnehmen. Weitere Details sind der genannten unveröffentlichten EP-Anmeldung zu entnehmen: Der dort in Fig. 1 dargestellte Sensor ist bis auf den Sensorstab identisch mir dem hier in Fig.3 dargestellten.

Der Sensorstab des in Fig. 3 dargestellten Sensors umfasst drei Paare erster und zweiter Schichten 1a,1b,1c, 2a,2b,2c. Die dicken Pfeile rechts neben dem Sensorstab veranschaulichen die kristalline Orientierung der Schichten, analog zu Figs. 1 und 2. Nicht alle der ersten Schichten 1a, 1b, 1c und nicht alle der zweiten Schichten 2a,2b,2c weisen dieselben Schichtdicken auf. Das mittlere Schichtpaar 1b,2b weist Schichtdicken $\delta_1'$ beziehungsweise $\delta_2'$ auf, die doppelt so gross sind wie die entsprechenden Schichtdicken $\delta_1$ beziehungsweise $\delta_2$ der anderen Schichten 1a,1c,2a, 2c.

Das für die vom Licht 5 in einem Schichtenpaar erfahrene Phasenverschiebung oder Polarisationsänderung relevante elektrische Feld ist das Feld am Ort des Schichtenpaars. Die Gesamtdicke jedes Schichtenpaares kann im Prinzip frei gewählt werden, so dass die zu messende Spannung V durch eine Summe von Teilsignalen, die an den im Prinzip frei wählbaren Orten der Schichtenpaare generiert werden, approximiert wird. Durch eine für jedes Schichtenpaar praktisch frei und individuell wählbare Schichtdickendifferenz zwischen der ersten und der zweiten Schicht des jeweiligen Schichtenpaares kann die genannte Summe von Teilsignalen fast beliebig gewichtet werden. Dadurch kann ein Sensoraufbau für einen gegebenen Feldverlauf optimiert werden, so dass genaue Messergebnisse erzielbar sind.

Die dargestellten Ausführungsbeispiele sind in Transmissionsgeometrie. Es ist selbstverständlich auch möglich, einen Sensor im Reflexionsgeometrie zu betreiben. Beispielsweise sind in den Figuren 4 und 5 der genannten unveröffentlichten EP-Anmeldung Sensor-Aufbauten in möglichen Reflexionsgeometrien dargestellt.

Fig. 4 zeigt eine weitere vorteilhafte Ausführungsform des Sensors. Sie kennzeichnet sich dadurch, dass die wesentlichen Teile, insbesondere die Feldsteuerungselektroden 3a,4a und der Sensorstab, mit Silikon 15 ummantelt sind. Weitere Details zu dieser Ausführungsform sind der genannten unveröffentlichten EP-Anmeldung entnehmbar, deren Figur 8 bis auf den anders gestalteten Sensorstab der Fig. 4 entspricht.

Weitere vorteilhafte Ausführungsformen können der genannten unveröffentlichten EP-Anmeldung, insbesondere den dortigen Figuren 6 und 7, entnommen werden. Dabei ist selbstverständlich ein Sensorstab entsprechend der vorliegenden Erfindung zu berücksichtigen.

Die weiter oben und im folgenden aufgeführten alternativen oder zusätzlichen Merkmale sind optional und untereinander sowie mit den in der Beschreibung genannten Ausführungsbeispielen beliebig kombinierbar.

Wie im Zusammenhang mit den Figuren 2 und 3 dargestellt, werden vorteilhaft mehrere Paare erster und zweiter Schichten aufgewiesen. Vorzugsweise werden alle Paare mit demselben einen Lichtstrahl 5 abgefragt. Aber es ist auch möglich, mehrere Lichtstrahlen vorzusehen, wobei ein Lichtstrahl jeweils mindestens ein Paar erster und zweiter Schichten abfragt. Der Lichtweg 5 kann auch optische Mittel wie Reflexionsmittel und optische Fasern aufweisen, mittels derer das Licht vor, zwischen oder nach Durchlaufen von zwischen den Elektroden angeordneten Schichten geführt wird.

Vorteilhaft verlaufen, wie oben beschrieben, der Lichtstrahl 5 und das elektrische Feld E parallel zu einer Hochsymmetrieachse des Kristalles. Die Doppelbrechungsachsen $a_{i,1}, a_{i,2}$ entsprechen also vorteilhaft Hochsymmetrieachsen des Kristalles. Bei kubischen Kristallen wie BGO verlaufen, wie oben beschrieben, der Lichtstrahl 5 und das elektrische Feld E vorzugsweise entlang der [100]-Richtung oder einer equivalenten Kristallrichtung ([010], [001]). Dies hat den Vorteil, dass Feldkomponenten, die zu dieser Richtung orthogonal sind, keinen Einfluss auf den Polarisationszustand oder die Phase des Lichtes 5 haben (geringe Störempfindlichkeit). Wenn die [100]-Richtung nicht entlang des Lichtstrahles 5 und des zu messenden Feldes verläuft, beeinflussen auch Feldkomponenten, die orthogonal zu dem zu messenden Feld sind, den Polarisationszustand oder die Phase des Lichtes 5. Ausserdem wird eine andere Ausrichtung im allgemeinen zu einem komplizierter auszuwertenden Spannungssignal führen. Hochsymmetrieachsen des Kristalles und der Lichtweg 5 und das elektrische Feld E sind also, wie oben beschrieben, vorzugsweise im wesentlichen parallel oder senkrecht zueinander ausgerichtet. Die Hochsymmetrieachsen der elektrooptisch aktiven Schichten können aber mit der Lichtausbreitungsrichtung und/oder mit der Richtung des elektrischen Feldes einen von 0° und einem Vielfachen von 90° verschiedenen Winkel einschliessen. Ebenso kann auch der von der Lichtausbreitungsrichtung und der Richtung des elektrischen Feldes eingeschlossene Winkel von 0° und einem Vielfachen von 90° verschieden sein. Details über die Abhängigkeit des elektro-optischen Effektes in beliebigen Kristallen von der Feld- und der Lichtausbreitungsrichtung sind beispielsweise dem Buch von J.F. Nye: "Physical Properties of Crystals", Oxford University Press, 1957 oder anderen Werken zur Kristalloptik zu entnehmen. Dem Fachmann ist es somit möglich, einen erfindungsgemässen Spannungssensor mit verschiedensten Winkeln zu realisieren.

Mit der Formulierung "kristalline Orientierung" ist hier im allgemeinen die durch die relevanten Achsen der Doppelbrechung $a_{i,1}, a_{i,2}$ definierte Orientierung der elektrooptisch aktiven Schichten gemeint. Zwar sind elektrooptisch aktive Materialien in der Praxis stets von kristalliner Struktur. Doch es ist denkbar, dass in nicht-kristallinen Materialien (wie beispielsweise Gasen, Flüssigkeiten, nicht-kristallinen Festkörpern) eine elektrooptische Aktivität der hier betrachteten Art vorliegt oder induzierbar ist, wobei diese Materialien dann zwar keine Kristallachsen, aber Achsen der Doppelbrechung aufweisen.

Selbstverständlich ist auch die in der genannten unveröffentlichten EP-Anmeldung ausführlich diskutierte Temperaturkompensation mit der vorliegenden Erfindung kombinierbar. Durch entsprechende Wahl der Schichtdicken und der Materialien der Schichten kann eine solche Temperaturkompensation erzielt werden. Insbesondere können schichtenpaarweise oder jeweils für die erste und für die zweite Schicht abwechselnd ein Kristall mit positiver und ein Kristall mit negativer Temperaturabhängigkeit seines jeweiligen massgeblichen elektrooptischen Koeffizienten und geeigneter Temperaturabhängigkeit der Dielektrizitätskonstante eingesetzt werden. In der Offenlegungsschrift EP 0 682 261 A2 sind verschiedene geeignete elektrooptisch aktive Materialien angegeben. Der Offenbarungsgehalt dieser Schrift ist hiermit ausdrücklich in die Beschreibung übernommen. Die Anordnung einer oder mehrerer nichtelektrooptisch aktiver Schichten zwischen den Elektroden 3,4 ist nicht zwingend erforderlich.

Da die Anzahl freier Parameter bei dem Design eines Sensors, der sowohl temperaturkompensiert ist als auch eine erfindungsgemäss erhöhte Halbwellenspannung hat, klein ist, werden dazu vorteilhaft verschiedene elektrooptisch aktive Materialien für die verschiedenen Schichten eingesetzt, da diese entsprechend anders temperaturabhängige Materialkonstanten aufweisen. Es können vorteilhaft auch nicht-elektrooptisch-aktive Abstandsschichten (entsprechend dem "Abstandsmedium" in der genannten unveröffentlichten EP-Anmeldung) im Sensorstab angeordnet sein, die dann einen entsprechenden Beitrag zu der Temperaturkompensation leisten. Beispielsweise eignet sich Quarzglas für eine solche Abstandsschicht. Vorzugsweise ist eine solche Zwischenschicht zwischen zwei Paaren erster und zweiter Schichten angeordnet, sie kann aber auch innerhalb eines Schichtenpaares angeordnet sein. Die Summe aller Schichtdicken erster und zweiter elektrooptisch aktiver Schichten wird also in einem solchen Fall kleiner als der Elektrodenabstand L sein.

Entsprechend dem allgemeinen Sprachgebrauch wird auch in der vorliegenden Anmeldung unter elektrooptischer Aktivität eine E-Feld-abhängige Änderung einer Doppelbrechung in einem zumeist kristallinen Material verstanden. Der Effekt kann linear sein (Pockels-Effekt) oder auch andere Abhängigkeiten von der elektrischen Feldstärke, beispielsweise eine quadratische, aufweisen. Ein elektrooptisch aktives Material kann bei E = 0 (verschwindendes elektrisches Feld) doppelbrechend sein oder auch nicht doppelbrechend sein. Doppelbrechung heisst, dass es für zwei zueinander orthogonale Achsen (der Doppelbrechung) zwei verschiedene Brechungsindices gibt, welche von Lichtwellen "erfahren" werden, deren Polarisation entlang einer solchen Achse ausgerichtet ist. Eine Änderung der Doppelbrechung kann bedeuten, dass sich nur ein einer Doppelbrechungsachse zugeordneter Brechungsindex ändert oder dass sich zwei solcher Brechungsindices verschiedenartig ändern, wobei letzteres durch eine Erhöhung des einen bei gleichzeitiger Erniedrigung des anderen Brechungsindexes oder auch durch eine verschieden starke Brechungsindex-Änderung gleichen Vorzeichens geschehen kann.

In den Ausführungsbeispielen wurde stets der longitudinale Pockels-Effekt (Lichtausbreitungsrichtung im wesentlichen parallel zum elektrischen Feld) ausgenutzt. Aber es ist im Prinzip auch möglich, den transversalen Pockels-Effekt (Lichtausbreitungsrichtung im wesentlichen senkrecht zum elektrischen Feld) zu nutzen und, je nach Art des elektrooptisch aktiven Materials und dessen kristalliner Orientierung, einen entsprechenden Sensor zu konstruieren. Grundsätzlich kann die Anordnung der elektrooptisch aktiven Schichten zwischen den Elektroden 3,4 beliebig sein. Beim longitudinalen Pockels-Effekt wird vorteilhaft die in den Ausführungsbeispielen gewählte Anordnung gewählt, so dass der Lichtweg 5 parallel zum elektrischen Feld E verläuft, und dass die elektrooptisch aktiven Schichten entlang des Elektrodenabstandes (entlang des elektrischen Feldes E) hintereinander angeordnet sind. Beim transversalen Pockels-Effekt können die Schichten ebenfalls in dieser Art angeordnet werden, wobei dann optische Mittel, wie Spiegel oder Glasfasern, aufgewiesen werden, mittels derer der Lichtstrahl 5 nach Austritt aus einer ersten Schicht 1a in eine zweite Schicht 2a gekoppelt werden kann, weil sich der Lichtstrahl 5 innerhalb der Schichten im wesentlichen senkrecht zum Sensorstab ausbreitet. In einem solchen Fall können die zwei Schichten relativ zueinander auch genau gleich orientiert sein oder sogar derselbe Kristall sein, wobei natürlich ihre relative Orientierung zum Lichtweg 5 (genauer: zu der durch den Lichtweg 5 in der jeweiligen Schicht vorgegebenen Lichtausbreitungsrichtung) verschieden ist. Alternativ kann auch bei beibehaltener Ausbreitungsrichtung die Polarisationsrichtung um 90° gedreht werden. In einer alternativen Anordnung beim transversalen Pockels-Effekt sind eine erste und eine zweite Schicht (gegebenenfalls mehrere jeweils paarweise) bezüglich des Elektrodenabstandes nebeneinander angeordnet, so dass keine optischen Mittel notwendig sind, um das Licht 5 von der ersten in die zweite Schicht zu führen. In diesem Fall bietet sich das paarweise Abfragen von Schichten mittels mehrerer Lichtstrahlen 5 besonders an. In den meisten Geoemtrien weist ein auf dem transversalen Pockels-Effekt basierender Sensor aber eine grosse Querempfindlichkeit auf (Beeinflussung durch äussere Felder, die nicht die gleiche Ausrichtung haben wie das zu messende Feld).

Der effektive Abstand L der Elektroden 3,4 ist in den Ausführungsbeispielen der Figuren die geometrische Länge, die das Licht 5 zwischen den Elektroden 3,4 zurücklegt. L entspricht somit dem geometrischen Minimalabstand zwischen den Elektroden 3,4. Der effektive Abstand L kann sich aber beispielsweise dann von dem geometrischen Abstand der Elektroden unterscheiden, wenn die Feldelektroden 3a,4a in radialer Richtung ein gebogenes Profil aufweisen, so dass der minimale geometrische Abstand zwischen den Feldelektroden 3a,4a im radialen Aussenbereich kleiner ist als im radialen Innenbereich, wo die transparenten Teile der Elektroden 3,4 angeordnet sind. Auch im Falle von nicht parallel zueinander ausgerichteter Elektroden 3,4 würde der geometrische minimale Abstand zwischen den Elektroden im allgemeinen nicht dem effektiven Abstand L der Elektroden 3,4 entsprechen. Der effektive Abstand L der Elektroden 3,4 kann von der Lichtführung abhängen.

Die effektiven Schichtdicken stimmen in den Ausführungsbeispielen mit den geometrischen Dicke der einzelnen Schichten des überein. Beispielsweise im Falle unebener Schicht-Oberflächen oder wenn die Schichten nicht planparallel ausgebildet sind, ist eine geometrische Schichtdicke nicht ohne weiteres definiert. Darum wurde der Begriff "effektiven Schichtdicke" eingeführt. Weitere Erläuterungen können der genannten unveröffentlichten EP-Anmeldung entnommen werden.

Obwohl sich vorteilhaft die ersten und zweiten Schichten von der einen Elektrode 3 bis zur anderen Elektrode 4 erstrecken, können auch andere Schichten (auch Gas, Flüssigkeiten, Vakkum) zwischen den Schichten oder zwischen den Schichten und einer oder beiden Elektroden angeordnet sein. Die Anordnung der elektrooptisch aktiven Schichten "zwischen dern Elektroden 3,4" bedeutet, dass die Schichten von dem elektrischen Feld E durchsetzt sind.

Weitere Varianten und Optionen sind der Zusammenschau der vorliegenden Anmeldung und der genannten unveröffentlichten EP-Anmeldung zu entnehmen.

Die genannten Merkmale können gemeinsam oder auch einzeln oder in beliebiger Kombination vorteilhaft sein.

Bezugszeichenliste

| 1a, 1b,... | erste elektrooptisch aktive Schicht, erster BGO-Kristall |
| 2a,2b,... | zweite elektrooptisch aktive Schicht, zweiter BGO-Kristall |
| 3 | Elektrode |
| 3a | Feldsteuerungselektrode |
| 3b | Spannungszuführung |
| 4 | Elektrode |
| 4a | Feldsteuerungselektrode |
| 4b | Spannungszuführung |
| 5 | Licht, Lichtstrahl, Lichtweg |
| 6a | optische Zuführungsfaser |
| 6b | optische Rückführungsfaser |
| 7a,7b | Kollimatorlinse |
| 8a,8b | Polarisator |

| | |
|---|---|
| 9 | λ/4-Element |
| 15 | Silikon |
| 16 | Lamellen (Beschirmung) |
| 17 | Koronaring |

$a_{i,1}, a_{i,2}$   Achsen der Doppelbrechung der i-ten elektrooptisch aktiven Schicht

$k_1$   massgeblicher elektrooptischer Koeffizient des Materials einer ersten Schicht

$k_2$   massgeblicher elektrooptischer Koeffizient des Materials einer zweiten Schicht

$n_{i,1}, n_{i,2}$   Brechungsindex, einer Achse der Doppelbrechung der i-ten elekt- rooptisch aktiven Schicht zugeordnet

$E$   elektrisches Feld, Feldlinie

$L$   effektiver Elektrodenabstand

$V$   zu messende elektrische Spannung

$V_\pi$   Halbwellenspannung

$\delta_1, \delta_1{}'$   effektive Schichtdicke einer ersten elektrooptisch aktiven Schicht

$\delta_2, \delta_2{}''$   effektive Schichtdicke einer zweiten elektrooptisch aktiven Schicht

$\Gamma, \Gamma_1, \Gamma_2$   Phasenverschiebung

**Patentansprüche**

1. Elektrooptischer Spannungssensor zur Messung einer elektrischen Spannung V, wobei die Spannung V zwischen zwei beabstandet angeordneten Elektroden (3,4) anliegt und ein elektrisches Feld E erzeugt, wobei zwischen den Elektroden (3,4) mindestens eine erste elektrooptisch aktive Schicht (1a,1b,1c,1d) und mindestens eine zweite elektrooptisch aktive Schicht (2a,2b,2c,2d) entlang eines Lichtweges (5) hintereinander angeordnet sind, wobei jede dieser Schichten (1a,1b,1c,1d; 2a,2b,2c, 2d) zwei Achsen der Doppelbrechung $a_{i,1}, a_{i,2}$ aufweist, denen jeweils ein Brechungsindex $n_{i,1}, n_{i,2}$ zugeordnet ist, und wobei in jeder dieser Schichten (1a,1b,1c,1d; 2a,2b,2c,2d) mindestens jeweils einer dieser Brechungsindices, $n_{i,1}$, durch das elektrische Feld E veränderbar ist, wodurch in jeder dieser Schichten (1a,1b,1c,1d; 2a,2b,2c,2d) eine Phase und/oder ein Polarisationszustand des Lichtes (5) beinflussbar ist, wobei der Index i = 1,2 die erste beziehungsweise zweite elektrooptisch aktive Schicht indiziert,
**dadurch gekennzeichnet, dass**
eine durch die Achsen der Doppelbrechung $a_{1,1}$, $a_{1,2}$ definierte Orientierung der mindestens einen ersten elektrooptisch aktiven Schicht (1a,1b,1c,1d) relativ zu dem Lichtweg (5) und dem elektrischen Feld E und eine durch die Achsen der Doppelbrechung $a_{2,1} a_{2,2}$ definierte Orientierung der mindestens einen zweiten elektrooptisch aktiven Schicht (2a,2b,2c,2d) relativ zu dem Lichtweg (5) und dem elektrischen Feld E derart gewählt sind, dass die Beeinflussung der Phase und/oder des Polarisationszustandes des Lichtes (5) in der ersten Schicht (1a,1b,1c,1d) der Beeinflussung der Phase und/oder des Polarisationszustandes des Lichtes (5) in der zweiten Schicht (2a,2b,2c,2d) entgegenwirkend ist.

2. Spannungssensor gemäss Anspruch 1, wobei mittels der Veränderungen der Brechungsindices $n_{i,1}$ für einen sich entlang des Lichtweges (5) ausbreitenden Lichtstrahl (5) eine Halbwellenspannung $V_\pi$ des Spannungssensors definierbar ist, **dadurch gekennzeichnet, dass** die durch die Achsen der Doppelbrechung $a_{1,1}, a_{1,2}$ definierte Orientierung der mindestens einen ersten elektrooptisch aktiven Schicht (1a,1b,1c,1d) relativ zu dem Lichtweg (5) und dem elektrischen Feld E und die durch die Achsen der Doppelbrechung $a_{2,1}, a_{2,2}$ definierte Orientierung der mindestens einen zweiten elektrooptisch aktiven Schicht (2a,2b,2c,2d) relativ zu dem Lichtweg (5) und dem elektrischen Feld E derart gewählt sind, dass die Halbwellenspannung $V_\pi$ des Sensors grösser ist als bei einem gleichartigen Sensor, der statt der mindestens einen zweiten elektrooptisch aktiven Schicht (2a,2b,2c,2d) mindestens eine Vergleichsschicht aufweist, die nicht elektrooptisch aktiv, aber ansonsten der mindestens einen zweiten elektrooptisch aktiven Schicht (2a,2b,2c,2d) gleichartig ist.

3. Spannungssensor gemäss einem der vorangegangenen Ansprüche, **dadurch gekennzeichnet, dass**

   - die durch die Achsen der Doppelbrechung $a_{1,1}$, $a_{1,2}$ definierte Orientierung der mindestens einen ersten elektrooptisch aktiven Schicht (1a, 1b,1c,1d) relativ zu dem Lichtweg (5) und dem elektrischen Feld E und

   - die durch die Achsen der Doppelbrechung $a_{2,1}$, $a_{2,2}$ definierte Orientierung der mindestens einen zweiten elektrooptisch aktiven Schicht (2a, 2b,2c,2d) relativ zu dem Lichtweg (5) und dem elektrischen Feld E, und

   - die Materialien der zwischen den Elektroden (3,4) angeordneten Schichten (1a,1b,1c,1d; 2a,2b,2c,2d) und

   - deren effektive Schichtdicken derart gewählt sind, dass die Beeinflussung der Phase und/oder des Polarisationszustandes des Lichtes (5) in der ersten Schicht (1a,1b,1c,1d) die Beeinflussung der Phase und/oder des Polarisationszustandes des Lichtes (5) in der zweiten Schicht (2a,2b,2c,2d) teilweise kompensiert.

4. Spannungssensor gemäss einem der vorangegangenen Ansprüche, **dadurch gekennzeichnet,**

**dass** die erste Schicht (1a,1b,1c,1d) und die zweite Schicht (2a,2b,2c,2d) dieselbe Kristallsymmetrie aufweisen, und dass die Schichten (1a,1b,1c,1d; 2a,2b,2c,2d) derart angeordnet sind, dass die kristalline Orientierung der zweiten Schicht (2a,2b,2c, 2d) sich aus der kristallinen Orientierung der ersten Schicht (1a,1b,1c,1d) durch eine Drehung der ersten Schicht (1a,1b,1c,1d) um 180° um eine der Achsen der Doppelbrechung $a_{1,1}$ oder $a_{1,2}$ ergibt.

5. Spannungssensor gemäss einem der vorangegangenen Ansprüche, **dadurch gekennzeichnet, dass** die erste elektrooptisch aktive Schicht (1a,1b, 1c,1d) aus demselben Material besteht wie die zweite elektrooptisch aktive Schicht (2a,2b,2c,2d).

6. Spannungssensor gemäss den Ansprüchen 4 und 5, **dadurch gekennzeichnet, dass** die mindestens eine erste elektrooptisch aktive Schicht (1a,1b,1c, 1d) mit einer effektiven Schichtdicke $\delta_1$ und die mindestens eine zweite elektrooptisch aktive Schicht (2a,2b,2c,2d) mit einer effektiven Schichtdicke $\delta_2$ zwischen den zwei Elektroden (3,4) angeordnet sind, wobei $\delta_1 \neq \delta_2$ gilt.

7. Spannungssensor gemäss einem der vorangegangenen Ansprüche, **dadurch gekennzeichnet, dass** eine Mehrzahl paarweise angeordneter erster und zweiter elektrooptisch aktiver Schichten (1a, 1b,1c,1d; 2a,2b,2c,2d) zwischen den Elektroden (3,4) entlang des Lichtweges (5) angeordnet ist.

8. Spannungssensor gemäss Anspruch 7, **dadurch gekennzeichnet, dass** die Mehrzahl paarweise angeordneter erster und zweiter elektrooptisch aktiver Schichten (1a,1b,1c,1d; 2a,2b,2c,2d) zwischen den Elektroden (3,4) derart angeordnet ist, dass eine Abweichung der mittels des Spannungssensors bestimmten Spannung von der zu messenden Spannung V minimal ist.

9. Spannungssensor gemäss einem der vorangegangenen Ansprüche, **dadurch gekennzeichnet, dass** die mindestens eine erste elektrooptisch aktive Schicht (1a,1b,1c,1d) und die mindestens eine zweite elektrooptisch aktive Schicht (2a,2b,2c,2d) oder die Mehrzahl paarweise angeordneter erster und zweiter elektrooptisch aktiver Schichten (1a, 1b,1c,1d; 2a,2b,2c,2d) stapelförmig zwischen den Elektroden (3,4) angeordnet sind, wobei die erste Schicht (1a) und die letzte Schicht (2a;2c;2d) in dem Stapel mit je einer der zwei Elektroden (3,4) in Kontakt ist, insbesondere wobei der Stapel im wesentlichen zylindrisch ausgestaltet ist.

10. Spannungssensor gemäss einem der vorangegangenen Ansprüche, **dadurch gekennzeichnet, dass** die Phase und/oder der Polarisationszustand des Lichtes (5) nach Austritt aus der zweiten elektrooptisch aktiven Schicht (2a,2b,2c,2d) detektierbar ist, wobei aus der detektierten Phase und/oder dem detektierten Polarisationszustand ein Spannungssignal bestimmbar ist, wobei die Materialien von zwischen den Elektroden (3,4) angeordneten Schichten (1a,1b,1c,1d; 2a,2b,2c,2d) und deren effektive Schichtdicken derart gewählt sind, dass Einflüsse der Temperatur auf die detektierte Phase und/oder den detektierten Polarisationszustand im wesentlichen kompensiert sind.

11. Spannungssensor gemäss einem der vorangegangenen Ansprüche, **dadurch gekennzeichnet, dass** zwischen den Elektroden (3,4) mindestens eine Abstandsschicht aus einem nicht elektrooptisch aktiven Material angeordnet ist.

12. Spannungssensor gemäss einem der vorangegangenen Ansprüche, **dadurch gekennzeichnet, dass** die mindestens eine erste elektrooptisch aktive Schicht (1a,1b,1c,1d) kristallines BGO ist, das mit seiner [001]-Richtung im wesentlichen entlang der einer durch den Abstand der zwei Elektroden definierten Koordinate verläuft, und dass die mindestens eine zweite elektrooptisch aktive Schicht (2a,2b,2c,2d) kristallines BGO ist, dessen [001] -Richtung der [001]-Richtung der mindestens einen ersten elektrooptisch aktiven Schicht (1a,1b,1c,1d) im wesentlichen entgegengesetzt orientiert ist, und wobei die [110]-Richtungen der mindestens zwei Schichten (1a,1b,1c,1d; 2a,2b,2c,2d) im wesentlichen parallel oder antiparallel zueinander ausgerichtet sind, und insbesondere wobei der Lichtweg (5) in der mindestens einen ersten elektrooptisch aktiven Schicht (1a,1b,1c,1d) und in der mindestens einen zweiten elektrooptisch aktiven Schicht (2a,2b,2c,2d) im wesentlichen entlang einer dieser [001]-Richtungen verläuft.

13. Spannungssensor gemäss einem der vorangegangenen Ansprüche, **dadurch gekennzeichnet, dass** mindestens die Elektroden (3,4) mitsamt der mindestens einen ersten elektrooptisch aktiven Schicht (1a,1b,1c,1d) und der mindestens einen zweiten elektrooptisch aktiven Schicht (2a,2b,2c, 2d) mit Silikon (15) ummantelt sind.

14. Verfahren zur Messung einer elektrischen Spannung V, wobei die Spannung V zwischen zwei voneinander beanstandet angeordneten Elektroden (3,4) anliegt und ein elektrisches Feld E erzeugt, wobei zwischen den Elektroden (3,4) mindestens eine erste elektrooptisch aktive Schicht (1a,1b,1c, 1d) angeordnet wird, welche von einem Lichtstrahl (5) durchlaufen wird, dessen Phase und/oder Polarisationszustand durch das elektrische Feld E in der ersten Schicht (1a,1b,1c,1d) beeinflusst wird, und wobei zwischen den Elektroden (3,4) mindestens eine zweite elektrooptisch aktive Schicht (2a,2b,2c, 2d) angeordnet wird, welche von dem Lichtstrahl (5) durchlaufen wird, dessen Phase und/oder Polarisationszustand durch das elektrische Feld E in der zweiten Schicht (2a,2b,2c,2d) beeinflusst wird, **dadurch gekennzeichnet, dass** die von dem Lichtstrahl (5) in der mindestens einen ersten Schicht (1a,1b,1c,1d) erfahrene Beeinflussung von der von dem Lichtstrahl (5) in der mindestens einen zweiten Schicht (2a,2b,2c,2d) erfahrenen Beeinflussung teilweise aufgehoben wird.

**Fig. 1**

**Fig. 2**

**Fig. 4**

**Fig. 3**

**Europäisches Patentamt**

**EUROPÄISCHER RECHERCHENBERICHT**

Nummer der Anmeldung

EP 03 40 5271

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| D,A | SANTOS ET AL. : "NEW MULTI-SEGMENT POCKELS DEVICE FOR HIGH-VOLTAGE MEASUREMENT" PROCEEDINGS OF THE INTERNATIONAL CONFERENCE ON ELECTRICAL ENGINEERING , Bd. 2, 12. - 15. August 1996, Seiten 1366-1370, XP008028187 * das ganze Dokument * --- | 1,14 | G01R15/24 G01R19/00 |
| A | EP 0 293 842 A (HAMAMATSU PHOTONICS KK) 7. Dezember 1988 (1988-12-07) * Spalte 12, Zeile 42 - Spalte 14, Zeile 46; Abbildungen 3,4 * --- | 1,14 | |
| A | US 4 631 402 A (MATSUMURA HIROYOSHI ET AL) 23. Dezember 1986 (1986-12-23) * Spalte 7, Zeile 20 - Spalte 9, Zeile 54; Abbildung 10 * --- | 1,6,14 | |
| A | PATENT ABSTRACTS OF JAPAN vol. 1998, no. 10, 31. August 1998 (1998-08-31) -& JP 10 132864 A (TOYO COMMUN EQUIP CO LTD), 22. Mai 1998 (1998-05-22) * Zusammenfassung; Abbildung 1 * --- | 1,14 | **RECHERCHIERTE SACHGEBIETE (Int.Cl.7)** G01R |
| A | MASAO OHTSUKA ET AL: "INFLUENCE OF OPTICAL ROTARY POWER ON OPTICAL VOLTAGE SENSOR USING BGO CRYSTAL" ELECTRONICS & COMMUNICATIONS IN JAPAN, PART II - ELECTRONICS, SCRIPTA TECHNICA. NEW YORK, US, Bd. 77, Nr. 5, 1. Mai 1994 (1994-05-01), Seiten 21-31, XP000485741 ISSN: 8756-663X * das ganze Dokument * --- | 1,14 | |

-/--

Der vorliegende Recherchenbericht wurde für alle Patentansprüche erstellt

| Recherchenort | Abschlußdatum der Recherche | Prüfer |
|---|---|---|
| DEN HAAG | 9. März 2004 | Koll, H |

**Europäisches Patentamt**

# EUROPÄISCHER RECHERCHENBERICHT

Nummer der Anmeldung

EP 03 40 5271

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | DE 197 16 477 A (JENAU FRANK ;SCHWARZ HARALD PROF DR ING (DE)) 24. September 1998 (1998-09-24) * Seite 4, Zeile 55 – Seite 8, Zeile 19 * | 1,14 | |
| A | US 2003/034768 A1 (KRAEMMER PETER) 20. Februar 2003 (2003-02-20) * Absatz '0031! – Absatz '0048!; Abbildung 1 * | 1,10,14 | |
| A | PATENT ABSTRACTS OF JAPAN vol. 016, no. 046 (P-1307), 5. Februar 1992 (1992-02-05) -& JP 03 249569 A (OMRON CORP), 7. November 1991 (1991-11-07) * Zusammenfassung * | 1,14 | |
| A | PATENT ABSTRACTS OF JAPAN vol. 017, no. 481 (P-1604), 31. August 1993 (1993-08-31) -& JP 05 119075 A (TOSHIBA CORP), 14. Mai 1993 (1993-05-14) * Zusammenfassung; Abbildung 3 * | 1,14 | RECHERCHIERTE SACHGEBIETE (Int.Cl.7) |

Der vorliegende Recherchenbericht wurde für alle Patentansprüche erstellt

| Recherchenort | Abschlußdatum der Recherche | Prüfer |
|---|---|---|
| DEN HAAG | 9. März 2004 | Koll, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

..............................................................................
& : Mitglied der gleichen Patentfamilie,übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 03 40 5271

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-03-2004

| Im Recherchenbericht angeführtes Patentdokument | | Datum der Veröffentlichung | Mitglied(er) der Patentfamilie | | Datum der Veröffentlichung |
|---|---|---|---|---|---|
| EP 0293842 | A | 07-12-1988 | JP | 2571385 B2 | 16-01-1997 |
| | | | JP | 63300969 A | 08-12-1988 |
| | | | EP | 0293842 A1 | 07-12-1988 |
| | | | DE | 3873422 D1 | 10-09-1992 |
| | | | DE | 3873422 T2 | 28-01-1993 |
| | | | DE | 3877628 D1 | 04-03-1993 |
| | | | DE | 3877628 T2 | 13-05-1993 |
| | | | EP | 0293841 A1 | 07-12-1988 |
| | | | US | 4866372 A | 12-09-1989 |
| | | | US | 4996475 A | 26-02-1991 |
| US 4631402 | A | 23-12-1986 | JP | 1754787 C | 23-04-1993 |
| | | | JP | 4044701 B | 22-07-1992 |
| | | | JP | 59147274 A | 23-08-1984 |
| | | | CA | 1211155 A1 | 09-09-1986 |
| | | | DE | 3404608 A1 | 16-08-1984 |
| | | | GB | 2135050 A ,B | 22-08-1984 |
| JP 10132864 | A | 22-05-1998 | KEINE | | |
| DE 19716477 | A | 24-09-1998 | DE | 19716477 A1 | 24-09-1998 |
| | | | CA | 2289736 A1 | 11-09-1998 |
| | | | WO | 9839662 A1 | 11-09-1998 |
| | | | EP | 0965046 A1 | 22-12-1999 |
| | | | JP | 2001513893 T | 04-09-2001 |
| US 2003034768 | A1 | 20-02-2003 | DE | 10140482 A1 | 13-03-2003 |
| | | | CN | 1407343 A | 02-04-2003 |
| | | | EP | 1284425 A2 | 19-02-2003 |
| | | | JP | 2003084014 A | 19-03-2003 |
| JP 03249569 | A | 07-11-1991 | KEINE | | |
| JP 05119075 | A | 14-05-1993 | KEINE | | |

EPO FORM P0461

Für nähere Einzelheiten zu diesem Anhang : siehe Amtsblatt des Europäischen Patentamts, Nr.12/82